# EUROPÄISCHE PATENTSCHRIFT

(11) **EP 0 444 714 B1**
(45) Veröffentlichungstag und Bekanntmachung des Hinweises auf die Patenterteilung: **18.05.1994**
(21) Anmeldenummer: 91104986.4
(22) Anmeldetag: 31.10.1988
(51) Int. Cl.: H01L 21/00

(54) **Vorrichtung zum Behandeln scheibenförmiger Gegenstände**
Holder device for processing disc-like articles
Dispositif support pour le traitement d'objet en forme de disque

(30) Priorität: 09.11.1987 AT 2958/87
(43) Veröffentlichungstag der Anmeldung: 04.09.1991
(62) Teilanmeldung aus: 88890271.5
(73) Patentinhaber: SEZ Semiconductor-Equipment Zubehör für die Halbleiterfertigung Gesellschaft m.b.H., A-9530 Bad Bleiberg 129 (Kärnten) (AT)
(72) Erfinder: Sumnitsch, Franz, A-9020 Klagenfurt (Kärnten) (AT)
(74) Vertreter: Beer, Manfred, Dipl.-Ing.

(56) Entgegenhaltungen:
- EP-A- 0 129 108

## Beschreibung

Die Erfindung betrifft eine Vorrichtung zum Behandeln scheibenförmiger Gegenstände, mit wenigstens zwei Behandlungsflüssigkeiten, insbesondere zum Ätzen von Siliziumscheiben, mit einem Träger für den zu behandelnden Gegenstand.

Beim Bearbeiten von scheibenförmigen Gegenständen, beispielsweise beim einseitigen Ätzen von Siliziumscheiben (Wafers) mit verschiedenen Säuren, ist es bislang notwendig, die nicht zu behandelnde Seite der Scheiben d.h. die Seite von Siliziumscheiben, die nicht geätzt werden soll, durch besondere Maßnahmen vor dem Angriff der Ätzflüssigkeiten zu schützen.

Aus dem IBM TECHNICAL DISCLOSURE BULLETIN Vol. 11 Nr. 2, Juli 1968, ist eine Vorrichtung zum Aufnehmen von Wafers bekannt, die nach dem Bernoulli-Prinzip arbeitet, wobei über einen mittigen Kanal Gas zugeführt und das zugeführte Gas durch eine Ringdüse, die innerhalb des Randes des wafers angeordnet ist, wieder abgezogen wird. Ein Gasaustritt zwischen dem Körper des Trägers und dem Wafer ist somit nicht vorgesehen.

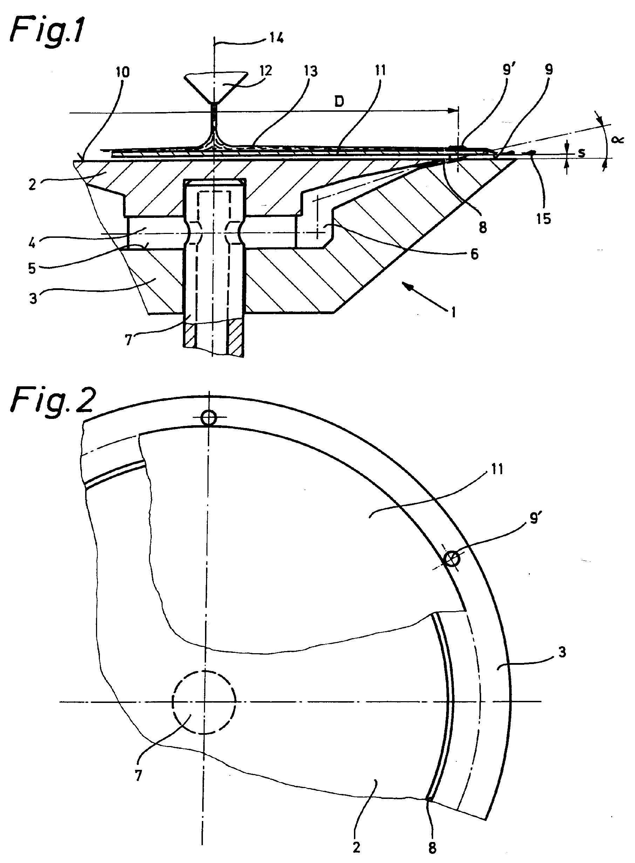

Dies gilt auch für die in IBM TECHNICAL DISCLOSURE BULLETIN, Vol. 20, Nr. 2, Juli 1977 gezeigte Vorrichtung, wozu insbesondere auf die dortige Fig. 2 verwiesen wird.

Die US-A-3 523 706 und das im vorliegenden Zusammenhang im wesentlichen offenbarungsgleiche IBM TECHNICAL DISCLOSURE BULLETIN, Vol. 18, Nr. 6, November 1975, zeigen jeweils eine Vorrichtung zum Aufnehmen von Scheiben, die nach dem Bernoulli-Prinzip arbeitet, wobei, wie aus Fig. 1a der US-A-3 523 706 ersichtlich, mehrere Düsen vorgesehen sind, die schräg zur der zu aufnehmenden Scheibe zugekehrten Fläche der Aufnahmevorrichtung ausgerichtet sind.

Die Erfindung stellt sich die Aufgabe, eine Vorrichtung zum Behandeln von scheibenförmigen Gegenständen, insbesondere zum Ätzen von Siliziumscheiben anzugeben, mit der die Behandlung, insbesondere das Ätzen von Siliziumscheiben besonders einfach durchgeführt werden kann, wobei die Behandlungsflüssigkeiten (Spülwasser und Säure) aufgefangen, und soferne möglich, einer Wiederverwendung zugeführt werden können.

In Lösung dieser Aufgabe ist die Vorrichtung gemäß Anspruch 1 erfindungsgemäß dadurch gekennzeichnet, daß der Träger im Innenraum eines runden Topfes angeordnet ist, wobei im Topf wenigstens zwei zu dessen Innenraum hin offene Ringkanäle zum Ansammeln der Behandlungsflüssigkeiten vorgesehen sind, und daß Einrichtungen vorgesehen sind, um die Relativlage zwischen Träger und Topf zu verändern.

Bei Verwendung der erfindungsgemäßen Vorrichtung zum Ätzen von Siliziumscheiben kann der Träger bei jedem Behandlungsschritt gegenüber dem entsprechenden Ringkanal im Topf höhenmäßig ausgerichtet werden, so daß vom Träger kommende Flüssigkeit in den Ringkanal eintritt.

In einer besonders einfachen Ausführungsform ist vorgesehen, daß der Träger über die ihn tragende Welle gegenüber dem Topf heb- und senkbar ausgebildet ist.

Die für den Betrieb der erfindungsgemäßen Vorrichtung vorteilhafte Drehbewegung des Trägers wird besonders erreicht, wenn der Welle des Trägers ein Motor zugeordnet ist, um den Träger in Drehung um seine Achse, die mit der Mittelachse des Topfes zusammenfällt, in Drehung zu versetzen.
Wenn, wie im Rahmen der Erfindung vorgesehen, die Welle für den Träger hohl ausgebildet ist und daß sie an eine Druckgasquelle angeschlossen ist, dann ist die Zufuhr des Druckgases besonders einfach.

In einer praktischen Ausführungsform der erfindungsgemäßen Vorrichtung ist diese dadurch ausgezeichnet, daß die ringförmigen, im Topf vorgesehenen Kanäle über schlitzförmige, höher als die Böden der Kanäle angeordnete Öffnungen zum Innenraum des Topfes hin offen sind. Bei dieser Ausführungsform besteht keine Gefahr, daß Dämpfe der Behandlungsflüssigkeit oder Sprühnebel aus der Vorrichtung unkontrolliert austreten.

Die erfindungsgemäße Vorrichtung kann sich noch dadurch auszeichnen, daß außerhalb der radial äußeren Wände der Kanäle im Topf ein Ringraum vorgesehen ist, der an eine Absaugvorrichtung angeschlossen ist und daß jeder der Kanäle über wenigstens eine im oberen Bereich seiner äußeren Wand vorgesehene Öffnung mit dem Ringraum verbunden ist.

Um die Behandlungsflüssigkeiten im Inneren des Topfes der erfindungsgemäßen Vorrichtung vorgesehenen Träger zuzuführen, empfiehlt es sich die Vorrichtung so auszubilden, daß von jeden Kanal eine Leitung zur Rückführung der in ihm angesammelten Flüssigkeit zur Wiederverwendung und/ oder zur Entsorgung angeschlossen ist.

Weiters kann noch vorgesehen sein, daß über dem im Innenraum des Topfes angeordneten Träger wenigstens eine Leitung ausmündet, über die dem Träger eine Behandlungsflüssigkeit zuführbar ist. Hiebei empfiehlt es sich, daß eine Leitung für die Zufuhr von Spülwasser, vorzugsweise deionisiertes oder destilliertes Wasser und wenigstens eine, vorzugsweise zwei Leitungen für die Zufuhr wenigstens einer Säure vorgesehen sind.

Weitere Einzelheiten und Merkmale der Erfindung ergeben sich aus der nachstehenden Beschreibung der in den Zeichnungen schematisch dargestellten Ausführungsbeispiele. Es zeigt
Fig. 1 im Schnitt teilweise einen Träger,
Fig. 2 eine Draufsicht hiezu,
Fig. 3 schematisch eine erfindungsgemäße Vorrichtung zum Ätzen von Siliziumscheiben, mit einem Träger gemäß den Fig. 1 und 2,
Fig. 4 einen Schnitt durch eine weitere Ausführungsform eines Trägers mit Lagereinheit und Antriebsmotor entlang der Linie IV-IV in Fig. 5 und
Fig. 5 eine Draufsicht auf die Träger aus Fig. 4, wobei zur besseren Darstellung Teile des Trägers nicht dargestellt sind.

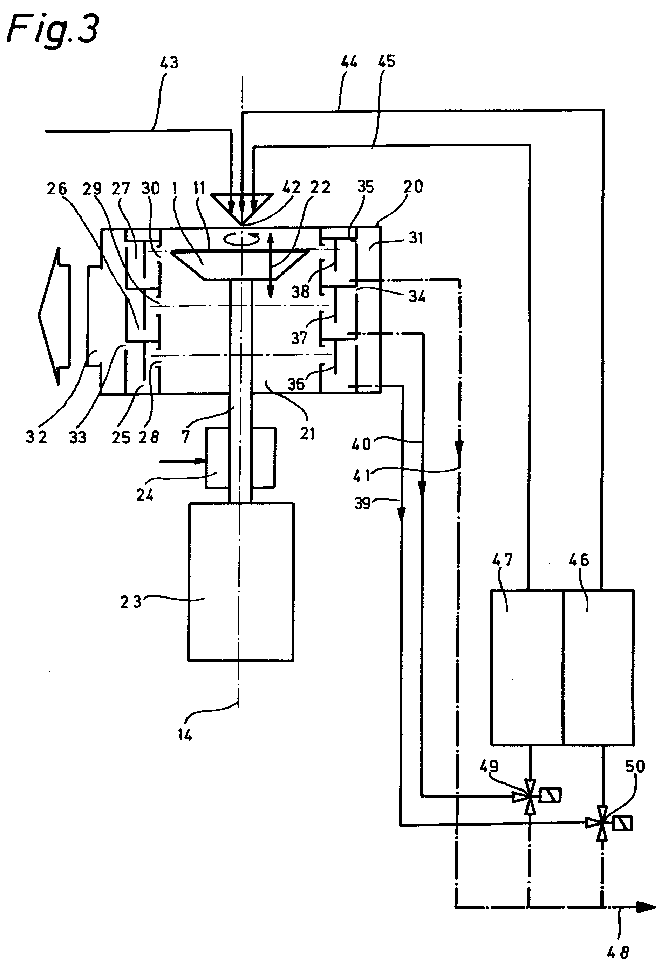

Die in Fig. 3 gezeigte Vorrichtung zum Ätzen von Siliziumscheiben - diese Vorrichtung kann sinngemäß auch zur Behandlung von anderen scheibenförmigen Gegenständen mit unterschiedlichen Behandlungsflüssigkeiten eingesetzt werden - besteht aus einem Topf 20, in dessen Innenraum 21 ein Träger 1 in Richtung des Doppelpfeiles 22 heb- und senkbar aufgenommen ist. Hiezu ist der die Welle 7 antreibende Motor 23 durch einen nicht näher gezeigten Antrieb auf- und abbeweglich.

Der Welle 7 ist eine Manschette 24 zugeordnet, über die in den in ihr vorgesehenen Hohlraum Druckgas, wie Druckluft oder Stickstoff zugeführt werden kann. Hiezu ist die Manschette 24 an eine Druckgasquelle angeschlossen.

Im Topf 20 sind übereinander drei Kanäle 25, 26 und 27 vorgesehen. Die ringförmigen Kanäle 25, 26 und 27 sind über ringförmige Schlitze 28, 29 und 30 zum Innenraum 21 des Topfs 20 offen.

Außerhalb der Kanäle 25, 26 und 27 ist im Topf 20 ein Ringraum 31 vorgesehen, der über einen Stutzen 32 an eine Absaugeinrichtung angeschlossen ist. Die Kanäle 25, 26 und 27 sind über Öffnungen 33, 34 und 35 mit dem Ringraum 31 verbunden.

In jedem Kanal 25, 26 und 27 sind Blenden 36, 37 und 38 vorgesehen, die im Abstand über dem Boden jedes Kanals 25, 26 und 27 enden. Diese Blenden 36, 37 und 38 verhindern, daß vom auf dem Träger 1 angeordneten scheibenförmigen Gegenstand, beispielsweise der Siliziumscheibe, abgeschleuderte Flüssigkeit unmittelbar zu den Austrittsöffnungen 33, 34 und 35 der Kanäle 25, 26 und 27 gelangen kann.

Von den Kanälen 25, 26 und 27 führen Leitungen 39, 40 und 41 weg.

Oberhalb des Trägers 1 münden, vorzugsweise in einer gemeinsamen Öffnung 42 Leitungen 43, 44 und 45 aus. Die Mündung bzw. die Mündungen der Leitungen 43, 44 und 45 sind gemeinsam mit dem Träger 1 gegenüber dem Topf 20 höhenverstellbar, um den Relativabstand zwischen dem Träger 1 und der Mündung 42 konstant zu halten. Über die Leitung 43 kann Spülwasser, beispielsweise deionisiertes Wasser zugeführt werden. Die Leitungen 44 und 45 gehen von Behältern 46 und 47 aus, in welchen die Behandlungsflüssigkeiten, z.B. Säuren vorrätig gehalten werden.

Die Leitung 41 vom Kanal 27 ist an eine Entsorgungsleitung 48 angeschlossen. Die Leitung 40 führt zu einem Dreiwegeventil 49 und die Leitung 39 zu einem Dreiwegeventil 50. Durch entsprechende Einstellung der Ventile 49 bzw. 50 kann aus den Kanälen 25 und/oder 26 abgezogene Flüssigkeit (Säure) entweder in die Vorratsbehälter 46 bzw. 47 rückgeführt oder zur Entsorgungsleitung 48 zugeführt werden.

In den Kanälen 25, 26 und 27 kondensieren die von der am Träger 1 angeordneten Siliziumscheibe abgeschleuderten feinen Säuretröpfchen bzw. Flüssigkeitströpfchen und die Flüssigkeiten werden dann über die Leitungen 39, 40 und 41 abgezogen.

Zum Transportieren der Flüssigkeiten können nicht näher gezeigte Pumpen vorgesehen sein.

Die Absaugeinrichtung, bestehend aus dem Ringraum 31 und dem Stutzen 32, der zu einer Saugpumpe führt, gewährleistet während des Betriebes der Vorrichtung eine definierte Luftströmung.

Nach dem Spülen des scheibenförmigen Gegenstandes 11 (Siliziumscheibe), während welchen Vorganges der Träger 1, wie in Fig. 3 dargestellt, gegenüber dem Kanal 27 ausgerichtet ist, wird die Drehzahl des Trägers 1 erhöht, so daß die Scheibe 11 durch Schleudern bei hoher Drehzahl getrocknet wird, ehe sie zur Entladung freigegeben wird.

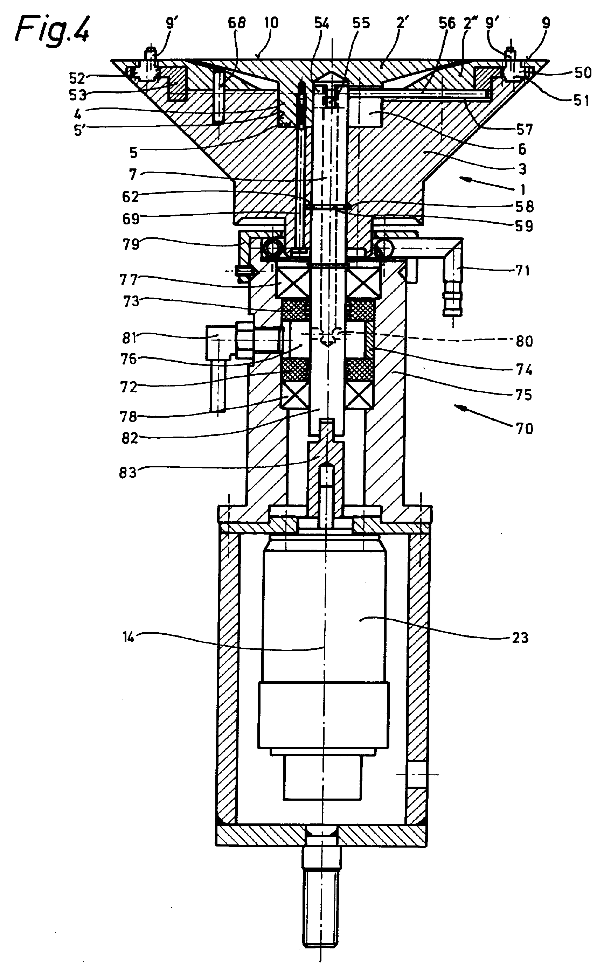

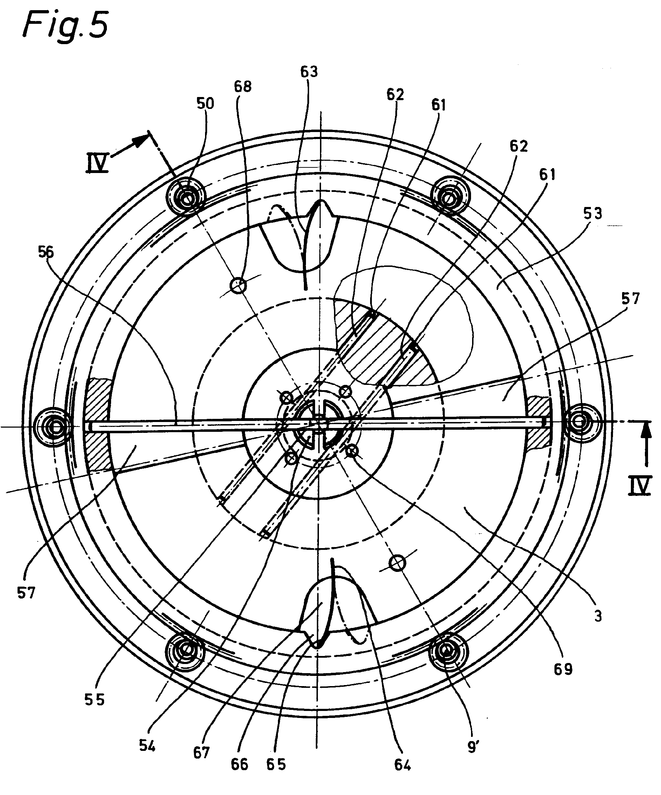

Der Träger 1, mit dem die scheibenförmigen Gegenstände in der Vorrichtung gehalten werden, besitzt mit Vorteil die in den Fig. 1 und 2 oder die in den Fig. 4 und 5 gezeigte und nachstehend beschriebene Konstruktion.

Der in Fig. 1 gezeigter Träger 1 ist rotationssymmetrisch ausgebildet und besteht aus einem inneren, vorzugsweise aus Metall gefertigten Teil 2 und einem äußeren, etwa topfförmigen, vorzugsweise aus Kunststoff bestehenden Teil 3. Der innere Teil 2 sitzt mit einem Ansatz 4 auf einer nach oben gerichteten Fläche 5 des äußeren Teils 3 auf, so daß die Relativlage der Teile 2 und 3 zueinander definiert ist.

Zwischen den beiden Teilen 2 und 3 des Trägers 1 ist ein Raum 6 vorgesehen, in den über eine hohl ausgebildete Welle 7 unter Druck stehendes Gas, wie beispielsweise Luft oder Stickstoff eingeführt werden kann. Der Raum 6 mündet in eine Ringdüse 8 aus, deren von den Teilen 2 und 3 gebildete Begrenzungswände mit der oberen Fläche des Trägers 1 einen spitzen Winkel α einschließen.

Die obere Endfläche des Trägers 1 wird von einer Kreisringfläche 9 des Teils 3 und einer Kreisfläche 10 des Teils 2 gebildet. Zwischen der Kreisringfläche 9 und der Kreisfläche 10 mündet die Ringdüse 8 an der Oberseite des Trägers 1 aus.

Von der Kreisringfläche 9 ragen Nocken 9' nach oben, die zur seitlichen Abstützung eines auf dem Träger 1 angeordneten, kreisrunden scheibenförmigen Gegenstandes 11 dienen. Der scheibenförmige Gegenstand 11 wird durch das über die Hohlwelle 7 zugeführte und aus der Düse 8 austretende Gas von der ihm zugekehrten Fläche des Trägers 1 (Kreisringfläche 9 und Kreisfläche 10) im Abstand S gehalten. Durch die besondere Ausbildung der Ringdüse 8 ergibt sich beim Ausströmen des Gases im Bereich D der dem Gegenstand 11 zugekehrten Fläche 9, 10 des Trägers 1 ein Unterdruck, durch den der scheibenförmige Gegenstand 11 niedergehalten und vom aus der Ringdüse 8 ausströmenden Gas nicht weggeblasen wird. Dabei ergibt sich der Vorteil, daß der Abstand S vom Druck des dem Raum 6 zugeführten, und aus der Ringdüse 8 ausströmenden Gases, weitgehend unabhängig ist.

In Fig. 1 ist noch gezeigt, daß über dem scheibenförmigen Gegenstand eine Leitung 12 ausmündet, durch die der oberen Fläche des scheibenförmigen Gegenstandes 11 eine Behandlungsflüssigkeit 13, beispielsweise eine Säure zum Ätzen einer Siliziumscheibe zugeführt werden kann. In Fig. 1 ist auch gezeigt, daß die auf den scheibenförmigen Gegenstand 11 aufgebrachte Behandlungsflüssigkeit auf seiner Oberseite einen Flüssigkeitsfilm bildet, dessen Dicke und Gleichmäßigkeit über die gesamte Fläche von der aufgebrachten Menge an Behandlungsflüssigkeit und der Drehzahl des Trägers 1 um seine Achse 14 abhängt. Der Film aus Behandlungsflüssigkeit reißt an der Außenkante des scheibenförmigen Gegenstandes 11 ab, und die Tröpfchen 15 werden zusätzlich vom aus der Ringdüse 8 ausströmenden Gas, wie in Fig. 1 angedeutet, weggeblasen, so daß die untere Seite des scheibenförmigen Gegenstandes 11 mit Behandlungsflüssigkeit nicht benetzt wird.

Bei der in den Fig. 4 und 5 dargestellten Ausführungsvariante eines Trägers 1 ist der Teil 2 durch einen Drehscheibenoberteil 2'' und einen Deckel 2' ersetzt. Der Dekkel 2' bildet die Kreisfläche 10 und der Drehscheibenoberteil 2'' die Kreisringfläche 9. Die Ringdüse 8 wird von den Begrenzungswänden des Drehscheibenoberteils 2'' und des Deckels 2' gebildet. Zwischen dem Drehscheibenoberteil 2'' und dem Teil 3 sind ein Zahnkranz 53 und die die Nocken 9' und Ritzel 52 tragenden Wellen 50 gelagert. Die Ritzel 52 der Wellen 50 und der Zahnkranz 53 sind miteinander im Eingriff. Die Nocken 9' sind exzentrisch auf den Wellen 50 angeordnet, so daß sich der radiale Abstand der Nocken 9' von der Mittelachse 14 bei Verdrehung der Wellen 50 durch den Zahnkranz 53 verändert.

Der Drehscheibenoberteil 2'' wird durch zwei Paßstifte 68 und einen nicht näher dargestellten Schnappverschluß am Teil 3 befestigt.

Der Deckel 2' ist durch den Ansatz 4 über eine nach oben gerichtete Fläche 5 und eine zylindrische Fläche 5' des Teiles 3 gelagert, so daß die Relativlage des Deckels 2' und des äußeren Teiles 3 zueinander definiert ist. Der Deckel 2' und der äußere Teil 3 sind durch vier Schrauben 69 in axialer Richtung fest miteinander verbunden. Durch das Einfügen von Beilagscheiben zwischen den Ansatz 4 des Deckels 2' und die Fläche 5 des äußeren Teiles 3 ist die Relativlage des Deckels 2' zum äußeren Teil 3 in axialer Richtung veränderbar, wodurch die Breite des Ringspaltes 8 zwischen dem Deckel 2' und dem Drehscheibenoberteil 2'' veränderbar ist.

Die Verdrehung der Nocken 9' auf den Wellen 50 erfolgt über den Zahnkranz 53. Der Antrieb des Zahnkranzes 53 erfolgt über eine Stange 56 durch die hohl ausgebildete Welle 7. Die Stange 56 ist mit ihren beiden Enden in Bohrungen, die im Zahnkranz 53 vorgesehen sind, und in einem Schlitz 55, der im Ende 54 der Welle 7 vorgesehen ist, gelagert. Der Schlitz 55, der zum Ende 54 der Welle 7 hin offen ist und in einer Axialebene der Welle 7 liegt, ermöglicht ein problemloses Aufschieben der Welle 7 auf die Stange 56. Weiters wird dadurch auch gewährleistet, daß der Deckel 2' gegenüber dem äußeren Teil 3 zur Veränderung der Breite des Ringspaltes 8 in axialer Richtung verschiebbar ist.

Um eine Verdrehung des Zahnkranzes 53 durch die Stange 56 zu ermöglichen, sind an der Oberseite des äußeren Teiles 3 kreisringstückförmige Ausnehmungen 57 vorgesehen, in denen sich die Stange 56 bei Verdrehung um die Mittelachse 14 bewegen kann. Diese Ausnehmungen 57 sind im besonderen aus Fig. 5 ersichtlich, in der zur besseren Darstellung der Deckel 2' und der Drehscheibenoberteil 2'' nicht gezeigt sind.

Um die Hohlwelle 7 im äußeren Teil 3 in axialer Richtung festzulegen, sind in der Welle 7 eine Ringnut 59 und in der Bohrung für die Welle 7 im äußeren Teil 3 eine Ringnut 58 vorgesehen, die einander gegenüberliegen. Weiters sind im äußeren Teil 3 zwei zueinander parallele, durch den Teil 3 gehende Bohrungen 61 vorgesehen, die zu beiden Seiten der Welle 7 liegen, mit ihren Mittelachsen die Welle 7 tangieren und durch die Ringnuten 58 und 59 durchführen. In die Bohrungen 61 werden Federstahlstifte 62 eingeführt, die durch die Ringnuten 58, 59 ragen und somit die hohle Welle 7 an einer axialen Verschiebung gegenüber dem äußeren Teil 3 hindern. Die äußeren Enden der Bohrungen 61 können z.B. verschweißt werden, um ein Herausfallen der Federstahlstifte 62 zu verhindern. Durch die erfindungsgemäße Ausführungsform dieser Befestigungseinrichtung ist es möglich, durch Aufbringung einer größeren Kraft, als sie beim Betrieb des Trägers auftritt, den Träger 1 von der Welle 7 in axialer Richtung abzuziehen, wobei die Federstahlstifte 62 aus der Ringnut 59 der Welle 7 hinausgedrückt werden.

Das untere Ende des äußeren Teiles 3 des Trägers 1 ragt in eine Lagereinheit 70, in der die Welle 7 durch zwei Lager 77, 78 gelagert ist. Das untere Ende des Trägers 1 ragt in das obere Ende der Lagereinheit 70 hinein. Zwischen dem unteren Ende des Trägers 1 und dem oberen Ende der Lagereinheit 70 ist eine Schlauchbremse 71 angeordnete, die das untere Ende des Trägers 1 umfaßt. Das obere Ende der Lagereinheit 70 ist durch einen kreisringförmigen Deckel 79 abgeschlossen, der das Herausrutschen der Schlauchbremse 71 verhindert.

Die Zufuhr des Druckgases in die hohle Welle 7 erfolgt in der Lagereinheit 70 zwischen den beiden Lagern 77 und 78. Dazu ist ein Ringraum 76 vorgesehen, der durch zwei Labyrinthdichtungen 72, 73, eine Hülse 74, die an der Innenseite der Gehäusewand 75 der Lagereinheit 70 anliegt, und die Welle 7 begrenzt wird. Der Ringraum 76 ist mit der Bohrung in der Welle 7 durch Bohrungen 80 verbunden. Die Zufuhr des Druckgases in den Ringraum 76 erfolgt durch eine Bohrung in der Gehäusewand 75 und eine Ausnehmung in der Hülse 74 über ein Anschlußstück 81, das in die Gehäusewand 75 eingeschraubt ist.

Die hohle Welle 7 ist an ihrem unteren Ende 82 über eine Kupplung 83 mit dem Motor 23 verbunden, der an der Lagereinheit 70 befestigt ist.

Die Bewegung der Nocken 9' erfolgt auf folgende Weise: Im Betrieb sind die Nocken 9' z.B. in der in Fig. 5 dargestellten radial innersten Lage. Der Träger 1 wird nun aus seiner Drehbewegung bis zum Stillstand abgebremst. Die Schlauchbremse 71 wird unter Druck gesetzt und hält den Träger 1 in seiner Relativlage zur Lagereinheit 70 fest. Der Motor 23 dreht nun kurz in die der Arbeitsdrehrichtung entgegengesetzte Drehrichtung. Diese Bewegung wird über die Welle 7 und die Stange 56 auf den Zahnkranz 53 übertragen. Die Stange 56 bewegt sich dabei in den kreisringstückförmigen Ausnehmungen 75 im äußeren Teil 3. Durch die Drehbewegung des Zahnkranzes 53 relativ zum äußeren Teil 3 bzw. dem Deckel 2' und dem Drehscheibenoberteil 2'' werden über die Ritzel 52 der Wellen 50 die Nokken 9' aus ihrer Arbeitsstellung in eine radial weiter außen liegende Stellung gedreht. Nun ist ein einfaches Wechseln des scheibenförmigen Gegenstandes 11 möglich. Anschließend beginnt sich der Motor 23 wieder in seine Arbeitsdrehrichtung zu drehen. Die Schlauchbremse 71 wird dabei noch kurzfristig unter Druck gehalten. Durch die dadurch entstehende Relativbewegung des Zahnkranzes 53 gegenüber dem Träger 1 werden die Nocken 9 wieder in ihre radial innere Stellung gedreht. Die Schlauchbremse 71 wird wieder gelöst und die Bearbeitung des nun eingespannten scheibenförmigen Gegenstandes 11 kann durchgeführt werden.

Die Öffnungs- und Schließbewegung der Nocken 9 kann noch durch zwei Blattfedern 63 unterstützt werden, die zwischen dem äußeren Teil 3 und dem Zahnkranz 53 wirken. Die beiden Blattfedern 63 sind mit ihrem einen Ende 64 in einen Schlitz im äußeren Teil 3 eingepreßt. Mit ihrem anderen Ende 65 greifen sie in eine Ausnehmung 66 im Zahnkranz 53 ein. Die beiden Blattfedern 63 stehen dabei vorzugsweise unter Vorspannung. Um eine Bewegung der Federn 63 zu ermöglichen, sind im äußeren Teil 3 Ausnehmungen 67 vorgesehen, die den Ausnehmungen 66 im Zahnkranz 53 gegenüberliegen.

Mit den beschriebenen Trägern ist sichergestellt, daß der zu behandelnde scheibenförmige Gegenstand, ohne auf dem Träger selbst flächig aufzuliegen, an diesem sicher gehalten ist. Weiters bewirkt das dem Träger zugeführte, aus der Düse austretende Gas, das den Gaspolster bildet, auf dem der Gegenstand liegt, daß vom Rand des zu behandelnden Gegenstandes wegströmende Flüssigkeit nicht auf die nicht zu behandelnde Unterseite des scheibenförmigen Gegenstandes gelangen kann, sondern von dem Rand des scheibenförmigen Gegenstandes weggeblasen wird. Bei Verwendung des erfindungsgemäßen Trägers ist auch gewährleistet, daß die Behandlungsflüssigkeit nicht durch Kapillarwirkung zwischen die dem scheibenförmigen Gegenstand zugekehrte Fläche des Trägers und dem scheibenförmigen Gegenstand hineingesaugt wird.

## Patentansprüche

1. Vorrichtung zum Behandeln scheibenförmiger Gegenstände, mit wenigstens zwei Behandlungsflüssigkeiten, insbesondere zum Ätzen von Siliziumscheiben, mit einem Träger (1) für den zu behandelnden Gegenstand (11) dadurch gekennzeichnet, daß der Träger (1) im Innenraum (21) eines runden Topfes (20) angeordnet ist, wobei im Topf (20) wenigstens zwei zu dessen Innenraum (21) hin offene Ringkanäle (25, 26, 27) zum Ansammeln der Behandlungsflüssigkeiten vorgesehen sind, und daß Einrichtungen vorgesehen sind, um die Relativlage zwischen Träger (1) und Topf (20) zu verändern.

2. Vorrichtung nach Anspruch 1, dadurch gekennzeichnet, daß der Träger (1) über die ihn tragende Welle (7) gegenüber dem Topf (20) heb- und senkbar ausgebildet ist.

3. Vorrichtung nach Anspruch 2, dadurch gekennzeichnet, daß der Welle (7) des Trägers (1) ein Motor (23) zugeordnet ist, um den Träger (1) um seine Achse (14), die mit der Mittelachse des Topfes (20) zusammenfällt, in Drehung zu versetzen.

4. Vorrichtung nach Anspruch 2 oder 3, dadurch gekennzeichnet, daß die Welle (7) für den Träger (1) hohl ausgebildet ist und daß sie an eine Druckgasquelle angeschlossen ist.

5. Vorrichtung nach einem der Ansprüche 1 bis 4, dadurch gekennzeichnet, daß die ringförmigen, im Topf (20) vorgesehenen Kanäle (25, 26, 27) über schlitzförmige, höher als die Böden der Kanäle (25, 26, 27) angeordnete Öffnungen (28, 29, 30) zum Innenraum (21) des Topfes (20) hin offen sind.

6. Vorrichtung nach einem der Ansprüche 1 bis 5, dadurch gekennzeichnet, daß außerhalb der radial äußeren Wände der Kanäle (25, 26, 27) im Topf (20) ein Ringraum (31) vorgesehen ist, der an eine Absaugvorrichtung angeschlossen ist und daß jeder der Kanäle (25, 26, 27) über wenigstens eine im oberen Bereich seiner äußeren Wand vorgesehene Öffnung (33, 34, 35) mit dem Ringraum (31) verbunden ist.

7. Vorrichtung nach einem der Ansprüche 1 bis 6, dadurch gekennzeichnet, daß an jedem Kanal (25, 26, 27) eine Leitung (39, 40, 41) zur Rückführung der in ihm angesammelten Flüssigkeit zur Wiederverwendung und/ oder zur Entsorgung angeschlossen ist.

8. Vorrichtung nach einem der Ansprüche 1 bis 7, dadurch gekennzeichnet, daß über dem im Innenraum (21) des Topfes (20) angeordneten Träger (1) wenigstens zwei Leitungen (43, 44, 45) ausmünden, über die dem Träger (1) wenigstens zwei Behandlungsflüssigkeiten zuführbar sind.

9. Vorrichtung nach Anspruch 8, dadurch gekennzeichnet, daß eine Leitung (43) für die Zufuhr von Spülwasser, vorzugsweise deionisiertes oder destilliertes Wasser und wenigstens eine, vorzugsweise zwei Leitungen (44, 45) für die Zufuhr wenigstens einer Säure vorgesehen sind.

10. Vorrichtung nach Anspruch 8 oder 9, dadurch gekennzeichnet, daß die Leitungen (43, 44, 45) in eine gemeinsame Mündung (42) enden.

11. Vorrichtung nach einem der Ansprüche 8 bis 10, dadurch gekennzeichnet, daß die Mündungen der Leitungen (43, 44, 45) oder die gemeinsame Mündung (42) der Leitungen (43, 44, 45) gemeinsam mit dem Träger (1) gegenüber dem Topf (20) höhenverstellbar sind.

## Claims

1. Device for processing disc-like articles, with at least two processing liquids, particularly for etching silicon discs, with a carrier (1) for the article (11) to be processed, characterised in that the carrier (1) is disposed in the inner space (21) of a round cup (20), there being provided in the cup (20) at least two annular ducts (25, 26, 27), open towards the inner space (21) thereof, for collecting the processing liquids, and in that arrangements are provided in order to alter the relative position between carrier (1) and cup (20).

2. Device according to claim 1, characterised in that the carrier (1) is designed to be raised and lowered above the shaft (7) carrying it, relative to the cup (20).

3. Device according to claim 2, characterised in that there is associated with the shaft (7) of the carrier (1) a motor (23) in order to rotate the carrier (1) about its axis (14) which coincides with the central axis of the cup (20).

4. Device according to claim 2 or 3, characterised in that the shaft (7) for the carrier (1) is hollow in form, and in that it is connected to a source of pressurised gas.

5. Device according to one of claims 1 to 4, characterised in that the annular ducts (25, 26, 27) provided in the cup (20) are open, via slot-shaped openings (28, 29, 30) disposed higher than the bases of the ducts (25, 26, 27), towards the inner space (21) of the cup (20).

6. Device according to one of claims 1 to 5, characterised in that there is provided. outwith the radially outer walls of the ducts (25, 27, 27) in the cup (20), an annular space (31) connected to a suction extractor, and in that each of the ducts (25, 26, 27) is connected to the annular space (31) by at least one opening (33, 34, 35) provided in the upper region of its outer wall.

7. Device according to one of claims 1 to 6, characterised in that there is connected to each duct (25, 26, 27) a pipe (39, 40, 41) for returning the and/ liquid collected therein for re-use and or disposal.

8. Device according to one of claims 1 to 7, characterised in that there open above the carrier (1) disposed in the inner space (21) of the cup (20) at least two pipes (43, 44, 45), at least two processing liquids being suppliable to the carrier (1) through said pipes.

9. Device according to claim 8, characterised in that there are provided a pipe (43) for supplying rinsing water, preferably deionised or distilled water, and at least one, preferably two pipes (44, 45) for supplying at least one acid.

10. Device according to claim 8 or 9, characterised in that the pipes (43, 44, 45) terminate in a common orifice (42).

11. Device according to one of claims 8 to 10, characterised in that the orifices of the pipes (43, 44, 45), or the common orifice (42) of the pipes (43, 44, 45) are vertically adjustable relative to the cup (20), in common with the carrier (1).

## Revendications

1. Dispositif pour le traitement d'objets en forme de disque au moyen d'au moins deux liquides de traitement, en particulier pour l'attaque chimique de disques de silicium, comportant un support (1) pour l'objet (11) à traiter, caractérisé par le fait que le support (1) est disposé dans la chambre intérieure (21) d'un pot (20) rond, au moins deux canaux annulaires (25,26,27) ouverts en direction de la chambre intérieure (21) du pot (20) étant prévus à l'intérieur dudit pot (20) pour collecter les liquides de traitement et par le fait qu'il est prévu des dispositifs pour modifier la position relative du support (1) et du pot (20).

2. Dispositif selon la revendication 1, caractérisé par le fait que le support (1) est agencé de manière à pouvoir être soulevé ou abaissé par rapport au pot (20) au moyen de l'arbre (7) qui le porte.

3. Dispositif selon la revendication 2, caractérisé par le fait qu'un moteur (23) est associé à l'arbre (7) du support (1) pour mettre en rotation le support (1) autour de son axe géométrique (14) qui coïncide avec l'axe médian du pot (20).

4. Dispositif selon la revendication 2 ou 3, caractérisé par le fait que l'arbre (7) du support (1) est creux et par le fait qu'il est connecté à une source de gaz sous pression.

5. Dispositif selon l'une des revendications 1 à 4, caractérisé par le fait que les canaux (25, 26, 27) annulaires prévus dans le pot (20) communiquent avec la chambre intérieure (21) du pot (20) par l'intermédiaire d'ouvertures (28,29,30) en forme de fentes qui sont disposées à un niveau plus élevé que le fond des canaux (25,26,27).

6. Dispositif selon l'une des revendications 1 à 5, caractérisé par le fait qu'il est prévu dans le pot (20), à l'extérieur des parois situées radialement à l'extérieur des canaux (25,26,27), une chambre annulaire (31) qui est raccordée à un dispositif d'aspiration et par le fait que chacun des canaux (25,26,27) communique avec la chambre annulaire (31) par au moins une ouverture (33,34,35) prévue dans la région supérieure de sa paroi extérieure.

7. Dispositif selon l'une des revendications 1 à 6, caractérisé par le fait qu'à chaque canal (25,26,27) est raccordée une conduite (39,40,41) pour ramener le liquide collecté par celui-ci à des fins de réutilisation et/ou d'élimination.

8. Dispositif selon l'une des revendications 1 à 7, caractérisé par le fait qu'au moins deux conduites (43,44,45) par l'intermédiaire desquelles au moins deux liquides de traitement peuvent être amenés au support (1) débouchent au dessus du support (1) disposé dan la chambre intérieure (21) du pot (20).

9. Dispositif selon la revendication 8, caractérisé par le fait qu'il est prévu une conduite (43) pour amener de l'eau de rinçage, de préférence de l'eau déionisée ou de l'eau distillée et au moins une, de préférence deux conduites (44,45) pour amener au moins un acide.

10. Dispositif selon la revendication 8 ou 9, caractérisé par le fait que les conduites (43,44,45) se terminent dans une embouchure (42) commune.

11. Dispositif selon l'une des revendications 8 à 10, caractérisé par le fait que les embouchures des conduites (43,44,45) ou l'embouchure commune (42) des conduites (43,44,45) peuvent être réglées en hauteur par rapport au pot (20) en même temps que le support (1).
